# EUROPEAN PATENT APPLICATION

(11) **EP 3 064 348 A1**
(43) Date of publication of application: **07.09.2016**
(21) Application number: 14857333.0
(22) Date of filing: 24.10.2014
(51) Int. Cl.: B32B 9/00

(54) **GAS BARRIER LAMINATED FILM**

(30) Priority: 28.10.2013 JP 2013223679
(71) Applicant: Toppan Printing Co., Ltd., Tokyo 110-0016 (JP)
(72) Inventor: TAKEUCHI Iori, Tokyo 110-0016 (JP); KASHIMURA Masayuki, Tokyo 110-0016 (JP); KAWAGUCHI Katsumi, Tokyo 110-0016 (JP)
(74) Representative: Hoffmann Eitle
(86) International application number: PCT/JP2014/078350
(87) International publication number: WO 2015/064503

(57) **Abstract**

A gas-barrier laminate film (5) which includes a film base material (1), a layer (2) that contains an inorganic compound (A) and is formed on one surface of the film base material, and two layers formed on the layer that contains the inorganic compound (A) so as to be adjacent to each other, wherein the two layers are made up of a layer (3) that contains a carboxylic acid polymer (B) and a layer (4) that contains at least one selected from a group consisting of a silicon compound (C) represented by the following general formula (I) and a hydrolysate thereof, and a vinyl alcohol polymer (D):

Si(OR¹)₄ (I)

(where R¹ represents an alkyl group with 1-4 carbon atoms, and the four R¹s may be identical or different).

## Description

### [Technical Field]

The present invention relates to gas-barrier laminate films used for packaging food products, pharmaceutical products and the like.

The present application is based on and claims the benefit of priority from Japanese Patent Application No. 2013-223679, filed on October 28, 2013, the contents of which are incorporated herein by reference.

### [Background Art]

Inorganic vapor deposition films are commonly used for gas-barrier laminate films which are used for packaging food products, pharmaceutical products and the like.

As an example of inorganic vapor deposition films, a film is disclosed in which the film includes a thin layer made of an inorganic oxide having a refractive index in the range from 1.51 to 1.65 (hereinafter, referred to as "inorganic compound layer") disposed on at least one surface of a film base material such as a polyester film (for example, see PTL 1). Such an inorganic vapor deposition film has a problem in that the inorganic compound layer is prone to damage by stress due to bending, stretching or the like, leading to decrease in gas barrier performance.

In order to solve the above problem, a method for increasing adhesiveness of the inorganic compound layer to the film base material has been discussed. As an example of the method for increasing adhesiveness of the inorganic compound layer to the film base material, providing a primer layer between the film base material and the inorganic compound layer is disclosed (for example, see PTL 2).

Further, in order to solve the above problem, a method for reducing the propagation of cracks generated in the inorganic compound layer to prevent decrease in gas barrier performance has been discussed. As an example of the method for reducing the propagation of cracks generated in the inorganic compound layer, providing a gas barrier coating layer on the inorganic compound layer is disclosed (for example, see PTL 3).

### [Citation List]

### [Patent Literature]

[PTL 1] JP-A-H09-123338
[PTL 2] JP-A-2010-229291
[PTL 3] JP-B-4045559

### [Summary of the Invention]

### [Technical Problem]

However, the inorganic vapor deposition films disclosed in PTLs 1 to 3 have a problem that it is difficult to keep high gas barrier performance after they are subject to stress due to bending, stretching or the like.

The present invention has been made in light of the above circumstance, and has an object to provide a gas-barrier laminate film having good gas barrier properties and good abuse resistance (resistance to hard use) in which the gas barrier properties are resistant to bending, stretching and the like.

### [Solution to Problem]

A gas-barrier laminate film according to an aspect of the present invention includes a film base material, a layer that contains an inorganic compound (A) and is formed on one surface of the film base material, and two layers formed on the layer that contains the inorganic compound (A) so as to be adjacent to each other, wherein the two layers are made up of a layer that contains a carboxylic acid polymer (B) and a layer that contains at least one selected from a group consisting of a silicon compound (C) represented by the following general formula (1) and a hydrolysate thereof, and a vinyl alcohol polymer (D):

Si(OR¹)₄ (1)

(where R¹ represents an alkyl group with 1-4 carbon atoms, and the four R¹s may be identical or different).

The layer that contains the inorganic compound (A) may be formed by a vapor deposition method, and made of at least one selected from a group consisting of aluminum, aluminum oxide, tin oxide, magnesium oxide and silicon oxide.

### [Advantageous Effects of Invention]

According to an aspect of the present invention, a gas-barrier laminate film can be provided having good gas barrier properties and good abuse resistance in which the gas barrier properties are resistant to bending, stretching and the like.

### [Brief Description of the Drawings]

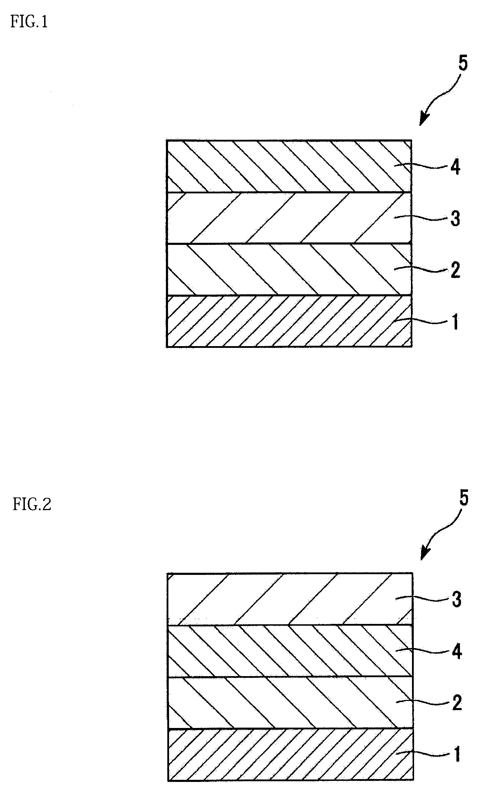

Fig. 1 is a cross sectional view of an example of a gas-barrier laminate film according to an embodiment of the present invention.
Fig. 2 is a cross sectional view of an example of a gas-barrier laminate film according to an embodiment of the present invention.

### [Description of Embodiments]

An embodiment of a gas-barrier laminate film of the present invention will be described.

The present embodiment is described in detail for better understanding of the principle of the invention, and should not be construed to limit the present invention unless otherwise specifically provided.

### [Gas-Barrier Laminate Film 5]

A gas-barrier laminate film 5 according to an embodiment of the present invention includes a film base material 1, a layer 2 that contains an inorganic compound (A) and is formed on one surface of the film base material 1, and two layers formed on the layer 2 that contains the inorganic compound (A) so as to be adjacent to each other. The two layers are made up of a layer 3 that contains a carboxylic acid polymer (B) and a layer 4 that contains at least one selected from a group consisting of a silicon compound (C) represented by the following general formula (1) and a hydrolysate thereof, and a vinyl alcohol polymer (D):

Si(OR¹)₄ (1)

(where R¹ represents an alkyl group with 1-4 carbon atoms, and the four R¹s may be identical or different).

In the gas-barrier laminate film 5 according to the present embodiment, the layer 3 that contains the carboxylic acid polymer (B) (hereinafter, referred to as "carboxylic acid polymer layer (B¹)3") and the layer 4 that contains one selected from a group consisting of the silicon compound (C) represented by the above general formula (1) and a hydrolysate thereof and the vinyl alcohol polymer (D) (hereinafter, referred to as "silicon compound-containing layer (C¹)4") are adjacent to each other and disposed on the layer 2 that contains the inorganic compound (A) (hereinafter, referred to as "inorganic compound layer (A¹)2"). This means that the inorganic compound layer (A¹)2, the carboxylic acid polymer layer (B¹)3 and the silicon compound-containing layer (C¹)4 are formed on one surface of the film base material 1 in this order, or alternatively, the inorganic compound layer (A¹)2, the silicon compound-containing layer (C¹)4 and the carboxylic acid polymer layer (B¹)3 are formed on one surface of the film base material 1 in this order. In addition, the inorganic compound layer (A¹)2 may not be necessarily adjacent to the carboxylic acid polymer layer (B¹)3 or the silicon compound-containing layer (C¹)4 as long as the carboxylic acid polymer layer (B¹)3 and the silicon compound-containing layer (C¹)4 are adjacent to each other on the inorganic compound layer (A¹)2.

That is, another layer may be interposed between the inorganic compound layer (A¹)2 and the carboxylic acid polymer layer (B¹)3 or the silicon compound-containing layer (C¹)4.

### [Film base material 1]

The film base material 1 may be, for example, a base material such as plastics, papers and rubbers. Of those base materials for the film base material 1, a base material that contains plastics is preferable in view of adhesiveness between the film base material 1 and the layer 2 that contains the inorganic compound (A).

Materials for plastics include, for example, polyolefin polymers such as low density polyethylene, high density polyethylene, linear low density polyethylene, polypropylene, poly 4-methylpentene and cyclic polyolefin, copolymers of those polyolefin polymers, and acid modified products of those polyolefin polymers; vinyl acetate copolymers such as polyvinyl acetate, ethylene-vinyl acetate copolymer, saponified ethylene-vinyl acetate copolymer and polyvinyl alcohol; polyester polymers such as polyethylene terephthalate, polybutylene terephthalate, polyethylene naphthalate, poly ε-caprolactone, polyhydroxybutyrate and polyhydroxyvalerate, and copolymers of those polyester polymers; polyamide polymers such as nylon 6, nylon 66, nylon 12, nylon 6-nylon 66 copolymer, nylon 6-nylon 12 copolymer, metaxylene adipamide/nylon 6 copolymer, copolymers of those amide polymers; polyether polymers such as polyethylene glycol, polyether sulfone, polyphenylene sulfide and polyphenylene oxide; chloride polymers or fluoride polymers such as polyvinyl chloride, polyvinylidene chloride, polyvinyl fluoride and polyvinylidene fluoride, copolymers of those chloride polymers or copolymers of those fluoride polymers; acrylic polymers such as polymethylacrylate, polyethylacrylate, polymethylmetacrylate, polyethylmetacrylate and polyacrylonitrile, and copolymers of those acrylic polymers; polyimide polymers, and copolymers of those polyimide polymers; resins such as alkyd resin, melamine resin, acryl resin, nitrocellulose, urethane resin, unsaturated polyester resin, phenolic resin, amino resin, fluoride resin and epoxy resin for paining; and natural polymer compounds such as cellulose, starch, pullulan, chitin, chitosan, glucomannnan, agarose and gelatin, and mixtures of those natural polymer compounds.

Further, the film base material 1 may be processed with a surface activation treatment such as corona treatment, flame treatment or plasma treatment in view of adhesion between the film base material 1 and an adhesive layer.

### [Inorganic compound (A)]

The layer 2 that contains the inorganic compound (A) (inorganic compound layer (A¹)2) is made of an inorganic oxide.

The inorganic oxide is appropriately selected from inorganic oxides that can form the inorganic compound layer (A¹)2 provided for imparting gas barrier properties to the gas-barrier laminate film 5 of the present embodiment, and may be, for example, aluminum oxide, silicon oxide, magnesium oxide and tin oxide.

The inorganic compound layer (A¹)2 has a thickness preferably in the range from 5 nm to 300 nm, more preferably in the range from 10 nm to 50 nm, although the thickness varies to some extent depending on the application of the gas-barrier laminate film 5 of the present embodiment or the film thickness of a gas barrier coating layer.

When the thickness of the inorganic compound layer (A¹)2 is less than 5 nm, there is a risk of the continuity of the inorganic compound layer (A¹)2 failing. On the other hand, when the thickness of the inorganic compound layer (A¹)2 is more than 300 nm, there is a risk of decrease in flexibility of the inorganic compound layer (A¹)2, leading to cracks in the inorganic compound layer (A¹)2 due to external factors such as bending and stretching after the inorganic compound layer (A¹)2 is formed.

Various methods are used for forming the inorganic compound layer (A¹)2. For example, common vacuum vapor deposition methods and other film formation methods such as sputtering methods, ion plating methods and chemical vapor deposition methods are used.

In vacuum vapor deposition methods, a vacuum vapor deposition apparatus preferably uses a heating method such as an electron beam heating method, a resistance heating method and an induction heating method. Further, in order to improve the adhesiveness of the inorganic compound layer (A¹)2 to the film base material 1 and the preciseness of the inorganic compound layer (A¹)2, a plasma assist method and an ion beam assist method can also be used as well as the above heating methods.

Further, in order to increase the transparency of the inorganic compound layer (A¹)2, reactive evaporation may be performed by injecting an oxygen gas into the inorganic compound layer (A¹)2 during vapor deposition process.

Preferably, the aluminum oxide has the molar abundance ratio of aluminum (Al) : oxygen (O) in the range from 1 : 1.5 to 1 : 2.0. For example, an aluminum oxide vapor deposition layer may be formed by a film formation method such as reactive evaporation, reactive sputtering or reactive ion plating by using aluminum as an evaporation material under the presence of a mixture gas of oxygen, carbon dioxide gas, inert gas and the like. Since the reaction of aluminum and oxygen generates Al₂O₃ in stoichiometry, the molar abundance ratio of aluminum (Al) : oxygen (O) is supposed to be 1 : 1.5. However, depending on the vapor deposition methods, some chemical species may remain as aluminum or may exist as aluminum peroxide. Accordingly, as seen from the element abundance ratio of the aluminum oxide vapor deposition layer measured by using X-ray photoelectron spectroscopy (XPS) or the like, the aluminum (Al) : oxygen (O) molar abundance ratio is not necessarily 1 : 1.5. In general, when the amount of oxygen is small and the amount of aluminum is large compared to the molar abundance ratio of aluminum (Al) : oxygen (O) = 1 : 1.5, the aluminum oxide vapor deposition layer is dense (due to the high density of the aluminum oxide vapor deposition layer). As a result, while the aluminum oxide vapor deposition layer has good gas barrier properties, it is discolored black and the light transmittance tends to decrease. On the other hand, when the amount of oxygen is large and the amount of aluminum is small compared to the molar abundance ratio of aluminum (Al) : oxygen (O) = 1 : 1.5, the aluminum oxide vapor deposition layer is coarse (due to the low density of the aluminum oxide vapor deposition layer). As a result, while the aluminum oxide vapor deposition layer has poor gas barrier properties, it is transparent and has a high light transmittance.

Silicon oxide is advantageously used particularly when the inorganic compound layer (A¹)2 is required to have water resistance.

### [Anchor coat layer]

The inorganic compound layer (A¹)2 may be disposed on one surface of the film base material 1 via an anchor coat layer in order to increase adhesiveness to the film base material 1.

Materials for the anchor coat layer include, for example, urethane resin, epoxy resin, acrylic resin and polyester resin.

Further, depending on the applications, an additive such as a hardener and a silane coupling agent may be added to the above materials for the anchor coat layer. In particular, the additive is preferably made up of a combination of an acryl polyol, an isocyanate compound and a silane coupling agent. The anchor coat layer having the above composition can provide a high and stable adhesiveness between the film base material 1 and the inorganic compound layer (A¹)2.

The anchor coat layer has a thickness preferably in the range from 0.01 µm to 2 µm, and more preferably in the range from 0.05 µm to 0.5 µm, although the thickness is not specifically limited as long as a uniform coat layer can be formed on one surface of the film base material 1.

When the thickness of the anchor coat layer is less than 0.01 µm, a uniform coat layer (anchor coat layer) is difficult to form, which may cause a decrease in adhesiveness of the inorganic compound layer (A¹)2 to the film base material 1. On the other hand, when the thickness of the anchor coat layer is more than 2 µm, the flexibility of the anchor coat layer is compromised. This is not preferable since there is a risk of cracks being formed in the anchor coat layer due to external factors.

The anchor coat layer with the thickness in the range from 0.05 µm to 0.5 µm is suitable for industrial production and provides good barrier properties.

### [Carboxylic acid polymer (B)]

The carboxylic acid polymer (B) is a polymer that contains two or more carboxyl groups in a molecule. The carboxylic acid polymer (B) includes, for example, polymers (copolymers) of ethylenic unsaturated carboxylic acid; copolymers of ethylenic unsaturated carboxylic acid and other ethylenic unsaturated monomers; and acidic polysaccharides that contains a carboxyl group in a molecule such as alginic acid, carboxymethyl cellulose and pectin. Those carboxylic acid polymers (B) can be used singly or in combination of two or more carboxylic acid polymers (B).

The ethylenic unsaturated carboxylic acid may be, for example, acrylic acid, methacrylic acid, itaconic acid, maleic acid, fumaric acid or crotonic acid.

Furthermore, the ethylenic unsaturated monomer that can copolymerize with the above ethylenic unsaturated carboxylic acid may be, for example, saturated carboxylic acid vinyl esters such as ethylene, propylene and vinyl acetate, alkyl acrylates, alkyl methacrylates, alkyl itaconates, vinyl chloride, vinylidene chloride, styrene, acryl amide or acrylonitrile.

In view of the gas barrier properties of the gas-barrier laminate film 5, it is preferable that the carboxylic acid polymer (B) is a polymer that contains a constitutional unit derived from a polymeric monomer of at least one selected from a group consisting of acrylic acid, maleic acid, methacrylic acid, itaconic acid, fumaric acid and crotonic acid, or a mixture of the polymer. Furthermore, it is more preferable that the carboxylic acid polymer (B) is a polymer that contains a constitutional unit derived from a polymeric monomer of at least one selected from a group consisting of acrylic acid, maleic acid, methacrylic acid, itaconic acid, or a mixture of the polymer. Further, those polymers may be homopolymers or copolymers.

In those polymers, the constitutional unit derived from a polymeric monomer of at least one selected from a group consisting of acrylic acid, maleic acid, methacrylic acid, itaconic acid is preferably 80 mol% or more, more preferably at least 90 mol% (where the whole constitutional unit is 100 mol%). Furthermore, when other constitutional units than the above constitutional unit are included in the polymers, they may be, for example, ethylenic unsaturated monomer that can copolymerize with the above ethylenic unsaturated carboxylic acid.

The carboxylic acid polymer (B) is preferably a polymer with a degree of polymerization of 20 to 20,000, more preferably a polymer with a degree of polymerization of 50 to 10,000 in view of water resistance of the gas-barrier laminate film 5.

When the carboxylic acid polymer (B) has a degree of polymerization less than 20, the gas-barrier laminate film 5 does not have a sufficient water resistance. In addition to that, the gas barrier properties and transparency of the gas-barrier laminate film 5 may be deteriorated by water, or alternatively, white discoloration may occur. On the other hand, when the carboxylic acid polymer (B) has a degree of polymerization more than 20,000, the viscosity of the carboxylic acid polymer (B) increases during application, leading to decrease in applicability of the carboxylic acid polymer (B).

The layer 3 (carboxylic acid polymer layer (B¹)3) that contains the carboxylic acid polymer (B) may also contain a zinc compound.

The carboxyl group of the carboxylic acid polymer (B) can be partially neutralized by zinc in advance to improve water resistance of the carboxylic acid polymer layer (B¹)3. The neutralization degree of the carboxyl group of the carboxylic acid polymer (B) is preferably 30 mol% or less, and more preferably 25 mol% or less in view of stability of coating liquid that contains the carboxylic acid polymer (B) (the coating liquid used for forming the carboxylic acid polymer layer (B¹)3).

The zinc compound may be, for example, a single element, oxide, hydroxide, carbonate, organic acid salt (e.g., acetate), inorganic acid salt, ammonium complex or secondary to quaternary amine complex of zinc or carbonate or organic acid salt thereof. Of those zinc compounds, zinc oxide and zinc acetate are preferably used, and zinc oxide is more preferably used in view of industrial productivity.

The carboxylic acid polymer layer (B¹)3 may contain a variety of additives.

The additives include silane coupling agent, plasticizer, resin, dispersant, surface activating agent, softener, stabilizer, anti-blocking agent, film-forming agent, adhesive and oxygen absorbent.

The plasticizer may be selected as appropriate, for example, from known plasticizers. Specific examples of the plasticizer may be, for example, ethylene glycol, trimethylene glycol, propylene glycol, tetramthylene glycol, 1,3-butanediol, 2,3-butanediol, pentamethylene glycol, hexamethylene glycol, diethylene glycol, triethylene glycol, polyethylene glycol, polyvinyl alcohol, ethylene-vinyl alcohol copolymer, polyethylene oxide, sorbitol, mannitol, dulcitol, erythritol, grycerin, lactic acid, fatty acid, starch or phthalate ester. Those plasticizer can be used singly or in combination of two or more plasticizer as appropriate.

Of those plasticizers, polyethylene glycol, polyvinyl alcohol, ethylene-vinyl alcohol copolymer, grycerin and starch are preferable in view of stretchability and gas barrier properties. When the plasticizer is contained in the carboxylic acid polymer layer (B¹)3, the abuse resistance of the carboxylic acid polymer layer (B¹)3 can be improved.

For the addition amount of the additive, the ratio of the mass of carboxylic acid polymer (B) to the mass of additive (carboxylic acid polymer (B) : additive) is preferably in the range from 70 : 30 to 99.9 : 0.1, more preferably in the range from 80 : 20 to 98 : 2.

A solvent used for a coating liquid that contains the carboxylic acid polymer (B) is preferably water or a mixed solvent of water and organic solvent, more preferably a mixed solvent of water and a lower alcohol having 1-5 carbons. In general, the mixed solvent contains 20 to 95 mass% of water and 80 to 5 mass% of organic solvent (in which the sum of water and organic solvent is defined as 100 mass%).

### [Silicon compound (C)]

The silicon compound (C) is a compound represented by the following general formula (1):

Si(OR¹)₄ (1)

(where R¹ represents an alkyl group with 1-4 carbon atoms, and the four R¹s may be identical or different).

The silicon compound (C) may be a silicon compound which generates silicon dioxide by hydrolysis and a hydrolysate thereof.

In the silicon compound (C), R¹ is preferably CH₃, C₂H₅ or C₂H₄OCH₃ for stable gelling.

As generally known, the hydrolysis of Si(OR¹)₄ is performed by using an acid catalyst or alkali catalyst, alcohol, and water. In particular, the hydrolysis using an acid catalyst is preferable since it is suitable for controlling the hydrolysis reaction of Si(OR¹)₄. In order to further control the hydrolysis reaction of Si(OR¹)₄, a generally known catalyst may be added.

### [Vinyl alcohol polymer (D)]

The vinyl alcohol polymer (D) is a polymer that has a main component such as polyvinyl alcohol (hereinafter, referred to as "PVA"), ethylene-vinyl alcohol copolymer, modified vinyl alcohol polymer or the like and contains vinyl alcohol. In particular, when PVA is used for the coating liquid that contains the vinyl alcohol polymer (D), the maximum gas barrier performance can be obtained.

The PVA is a compound which is generally obtained by saponification of polyvinyl acetate, and includes a fully saponified PVA having a few % of acetate group.

The PVA has a degree of polymerization in the range from 300 to several thousands. The degree of polymerization of the PVA is not specifically limited, and in general, the PVA having a high saponification degree and a high degree of polymerization is preferable since it has high water resistance.

The degree of polymerization of the vinyl alcohol polymer is preferably in the range from 500 to 3000, more preferably in the range from 1000 to 3000.

When the degree of polymerization of vinyl alcohol polymer is smaller than 500, sufficient film-forming properties are not achieved. When the degree of polymerization of vinyl alcohol polymer is larger than 3000, the viscosity of the vinyl alcohol polymer increases and liquid preparation and application using the vinyl alcohol polymer becomes difficult.

The vinyl alcohol polymer having the degree of polymerization in the range from 1000 to 3000, the resultant gas-barrier laminate film 5 exhibits good gas barrier properties, film-forming properties and abuse resistance.

For the gas-barrier laminate film 5 of the present embodiment, the mass compounding ratio of the silicon compound (C) (SiO₂ conversion) to the vinyl alcohol polymer (D) is preferably in the range from 30/70 to 70/30, more preferably in the range from 35/65 to 65/35, and further more preferably in the range from 40/60 to 60/40.

When the mass compounding ratio of the silicon compound (C) to the vinyl alcohol polymer (D) is in the range from 30/70 to 70/30, the resultant gas-barrier laminate film 5 exhibits sufficient barrier properties, abuse resistance and water resistance. Further, when the mass compounding ratio of the silicon compound (C) to the vinyl alcohol polymer (D) is in the range from 35/65 to 65/35, the barrier properties, abuse resistance and water resistance can be improved. Further, when the mass compounding ratio of the silicon compound (C) to the vinyl alcohol polymer (D) is in the range from 40/60 to 60/40, the barrier properties, abuse resistance and water resistance can be further improved.

The application method of the anchor coat layer, the carboxylic acid polymer layer (B¹)3 and silicon compound-containing layer (C¹)4 includes, but is not specifically limited to, a cast method, a dipping method, a roll coating method, a gravure coating method, a screen printing method, a reverse coating method, a spray coating method, a kit coating method, a die coating method, a metaling bar coating method, a chamber doctor combination coating method and a curtain coating method.

Further, although the application and drying of layers is performed continuously, the application of layers may be performed continuously or via a winding process or a curing process when two or more layers are disposed.

The drying method of the anchor coat layer, the carboxylic acid polymer layer (B¹)3 and the silicon compound-containing layer (C¹)4 includes, but is not specifically limited to, a hot-air drying method, a hot roll contact method, an infrared heating method and a microwave heating method. Those methods can be used singly or in combination.

The drying temperature is usually preferably in the range from 50 to 160 °C when water or a mixed solvent of water and organic solvent is used as a solvent, but is not specifically limited thereto.

Further, drying is usually preferably performed under normal pressure or reduced pressure. For the convenience of facility, normal pressure is preferable.

In the gas-barrier laminate film 5 of the present embodiment, another base material may be formed for a purpose of providing strength, sealing properties, easiness of seal opening, design ability or light shielding properties.

Although another base material may be appropriately selected depending on the applications, plastic films or papers are used in general.

Further, the plastic films or papers may be used singly or in combination of two or more in a stacked manner, or alternatively, the plastic films and papers may be used in a stacked manner.
Methods for providing another base material on the gas-barrier laminate film 5 may be, for example, lamination methods using an adhesive. Specific examples of the lamination methods may be, for example, a dry lamination method, a wet lamination method or extrusion lamination method.

Further, another base material may undergo printing or vapor deposition in view of providing design ability, light shielding properties or moisture prevention properties.

According to the present embodiment, the gas-barrier laminate film 5 having good gas barrier properties and good abuse resistance in which the gas barrier properties are resistant to bending, stretching and the like is provided.

The gas-barrier laminate film 5 according to the present embodiment exhibits high abuse resistance due to the carboxylic acid polymer (B), the silicon compound (C) and the vinyl alcohol polymer (D) interacting to each other so as to hold high adhesiveness and complement the properties of the respective layers. For example, in the configuration of [film base material made of polyethylene terephthalate/inorganic compound layer (A¹)/silicon compound-containing layer (C¹)/carboxylic acid polymer layer (B¹)], the carboxylic acid polymer layer (B¹)3 repairs the cracks generated by abuse (hard use) of the gas-barrier laminate film 5 so that the gas-barrier laminate film 5 exhibits high gas barrier properties after abuse. On the other hand, in the configuration of [film base material made of polyethylene terephthalate/inorganic compound layer (A¹)/carboxylic acid polymer layer (B¹)/silicon compound-containing layer (C¹)], the silicon compound-containing layer (C¹)4 prevents the deterioration of the barrier properties caused by swelling of the carboxylic acid polymer layer (B¹)3 so that the gas-barrier laminate film 5 can exhibit high gas barrier properties.

Further, the carboxylic acid polymer layer (B¹)3 has high flexibility, and the silicon compound-containing layer (C¹)4 has high water resistance.

### Example

The present invention will be further described in detail by means of the examples and comparative examples. However, the present invention is not limited to those examples.

### [Preparation example 1]

PVA with a degree of polymerization of 2400 (PVA124, manufactured by Kuraray Co., Ltd.) was diluted with water/methyl alcohol = 90/10 (mass ratio) so that a solid content was at 5 mass%, thereby preparing PVA solution.

Then, 0.1N hydrochloric acid (N is a specified concentration) was added to tetraethoxysilane (Si(OC₂H₅)₄, hereinafter, referred to as "TEOS"), and the mixture was stirred for 30 minutes. TEOS was hydrolyzed to prepare hydrolyzed solution of TEOS with a solid content 3 mass% (SiO convertion).

Then, PVA solution and TEOS hydrolyzed solution were mixed so that the mass ratio of PVA solid content and SiO solid content (converted value) of TEOS was at 50/50, thereby preparing a coating liquid (a1).

### [Preparation example 2]

PVA solution and TEOS hydrolyzed solution were mixed in the same manner as Preparation example 1 except that the mass ratio of PVA solid content and SiO solid content (converted value) of TEOS was at 70/30, thereby preparing a coating liquid (a2).

### [Preparation example 3]

PVA solution and the hydrolyzed solution were mixed in the same manner as Preparation example 1 except that the mass ratio of PVA solid content and SiO solid content (converted value) of TEOS was at 30/70, thereby preparing a coating liquid (a3).

### [Preparation example 4]

A coating liquid (a4) was prepared in the same manner as Preparation example 2 except that PVA with a degree of polymerization of 2400 was replaced with PVA with a degree of polymerization of 1000 (PVA110, manufactured by Kuraray Co., Ltd.).

### [Preparation example 5]

Polyacrylic acid (Trade name: Alon A-10H, 25 mass% aqueous solution, manufactured by Toa Gosei Co., Ltd.) was dissolved with distilled water to prepare polyacrylic acid aqueous solution with a solid concentration of 10 mass%.

Then, zinc oxide was added to the polyacrylic acid aqueous solution having a solid concentration 10 of mass% so that the zinc amount was at 20 mol% of the number of moles of carboxyl groups in the polyacrylic acid aqueous solution, thereby preparing polyacrylic acid zinc-neutralized aqueous solution.

Then, the polyacrylic acid zinc-neutralized aqueous solution was diluted with water and isopropyl alcohol to water/isopropyl alcohol = 60/40 (mass ratio), thereby preparing a coating liquid (b1) with a solid concentration of 5 mass%.

### [Preparation example 6]

Polyacrylic acid (Trade name: Alon A-10H, 25 mass% aqueous solution, manufactured by Toa Gosei Co., Ltd.) was dissolved with water and isopropyl alcohol to water/isopropyl alcohol = 60/40 (mass ratio), thereby preparing a coating liquid (b2) with a solid concentration of 5 mass%.

### [Example 1]

Metal aluminum was evaporated on a biaxially oriented polyethylene terephthalate (PET) film (Trade name: Lumirror P60, thickness 12 µm, inner corona treatment, manufactured by Toray Industries, Inc.) by a vacuum vapor deposition apparatus using an electronic beam heating method. An oxygen gas was introduced into the aluminum vapor so that aluminum oxide was deposited on the PET film, thereby preparing an inorganic compound layer with a thickness of 20 nm.

Then, the coating liquid (a1) was applied on the inorganic compound layer by a bar coater, and dried by a drying machine at 120°C for one minute, thereby forming a coating film (coating liquid (a1) layer) with a film thickness of approximately 0.3 µm.

Then, the coating liquid (b1) was applied on the coating liquid (a1) layer by a bar coater, and was dried by using a dryer, thereby forming a coating film (coating liquid (b1) layer) with a film thickness of approximately 0.3 µm. Accordingly, a gas-barrier laminate film having a configuration of [PET film/inorganic compound layer/coating liquid (a1) layer/coating liquid (b1) layer] was obtained.

### [Example 2]

In the same manner as Example 1 except for the stacking order of the coating liquid (a1) layer and the coating liquid (b1) layer, a gas-barrier laminate film having a configuration of [PET film/inorganic compound layer/coating liquid (b1) layer/coating liquid (a1) layer] was obtained.

### [Example 3]

In the same manner as Example 1 except that the coating liquid (a1) was replaced with the coating liquid (a4), a gas-barrier laminate film having a configuration of [PET film/inorganic compound layer/coating liquid (a4) layer/coating liquid (b1) layer] was obtained.

### [Example 4]

In the same manner as Example 3 except for the stacking order of the coating liquid (a4) layer and the coating liquid (b1) layer, a gas-barrier laminate film having a configuration of [PET film/inorganic compound layer/coating liquid (b1) layer/coating liquid (a4) layer] was obtained.

### [Example 5]

In the same manner as Example 1 except that the coating liquid (a1) was replaced with the coating liquid (a2), a gas-barrier laminate film having a configuration of [PET film/inorganic compound layer/coating liquid (a2) layer/coating liquid (b1) layer] was obtained.

### [Example 6]

In the same manner as Example 5 except for the stacking order of the coating liquid (a2) layer and the coating liquid (b1) layer, a gas-barrier laminate film having a configuration of [PET film/inorganic compound layer/coating liquid (b1) layer/coating liquid (a2) layer] was obtained.

### [Example 7]

In the same manner as Example 1 except that the coating liquid (b1) was replaced with the coating liquid (b2), a gas-barrier laminate film having a configuration of [PET film/inorganic compound layer/coating liquid (a1) layer/coating liquid (b2) layer] was obtained.

### [Example 8]

In the same manner as Example 7 except for the stacking order of the coating liquid (a1) layer and the coating liquid (b2) layer, a gas-barrier laminate film having a configuration of [PET film/inorganic compound layer/coating liquid (b2) layer/coating liquid (a1) layer] was obtained.

### [Comparative example 1]

Metal aluminum was evaporated onto a biaxially oriented polyethylene terephthalate (PET) film (Trade name: Lumirror P60, thickness 12 µm, inner corona treatment, manufactured by Toray Industries, Inc.) by a vacuum vapor deposition apparatus using an electronic beam heating method. Oxygen gas was introduced into the aluminum vapor so that aluminum oxide was deposited on the PET film, thereby preparing an inorganic compound layer with a thickness of 20 nm.

Then, the coating liquid (a1) was applied on the inorganic compound layer by a bar coater, and dried by a drying machine at 120°C for one minute, thereby forming a coating film (coating liquid (a1) layer) with a film thickness of approximately 0.6 µm. Accordingly, the gas-barrier laminate film was obtained.

### [Comparative example 2]

In the same manner as Comparative example 1 except that the coating liquid (a1) was replaced with the coating liquid (a2), a gas-barrier laminate film was obtained.

### [Comparative example 3]

In the same manner as Comparative example 1 except that the coating liquid (a1) was replaced with the coating liquid (a3), a gas-barrier laminate film was obtained.

### [Comparative example 4]

In the same manner as Comparative example 1 except that the coating liquid (a1) was replaced with the coating liquid (b1), a gas-barrier laminate film was obtained.

The gas-barrier laminate films obtained by Examples 1 to 8 and Comparative examples 1 to 4 were adhered to Ny (oriented nylon film) and CPP (polypropylene film) in sequence by using an adhesive by a multi-coater TM-MC manufactured by Hirano Tecseed Co., Ltd., thereby obtaining a laminate film having a configuration of [gas-barrier laminate film/adhesive/Ny/adhesive/CPP]. The stacked surfaces were disposed so as to face the adhesive. The stacked surfaces referred to surfaces on which the respective layers of the gas-barrier laminate film were stacked.

Further, the gas-barrier laminate films obtained by Examples 1 to 8 and Comparative examples 1 to 4 were adhered to LLDPE (linear low density polyethylenefilm), thereby obtaining a laminate film having a configuration of [gas-barrier laminate film/adhesive/LLDPE].

The adhesive used was the two-liquid curing type adhesive manufactured by Mitsui Chemicals, Inc., Takelac A620 (base resin)/Takenate A65 (hardener).

The Ny used was the oriented nylon film manufactured by Unitika Ltd., Emblem ONMB (15 µm).

The CPP used was the polypropylene film manufactured by Toray Advanced Film Co., Ltd., Torayfan ZK93FM (60 µm).

The LLDPE used was the linear low density polyethylenefilm manufactured by Mitsui Chemicals Tohcello Inc., TUX-TCS (60 µm).

The obtained laminate films were each cured at 40°C for three days.

### [Evaluation]

### (1) Evaluation of bending resistance

The obtained laminate films (configuration: gas-barrier laminate film/adhesive/NY/adhesive/CPP) were cut into a piece of 295 mm length x 210 mm width.

The cut piece of the laminate film was attached on a fixed head of Gelbo Flex Tester manufactured by Tester Sangyo Co., Ltd. in a cylindrical shape with 87.5 mm diameter x 210 mm.

The laminate film was bent by applying a twist at 440 degrees with a stroke of 87.5 mm and an initial gripping interval of 175 mm while the both ends of the laminate film were held. This motion was repeated back-and-forth up to 50 times at a rate of 40 times/min.

The evaluation results were shown in Table 1.

### (2) Evaluation of stretch resistance

The obtained laminate films (configuration: gas-barrier laminate film/adhesive/LLDPE) were cut into a piece of 200 mm length x 150 mm width.

The cut piece of the laminate film was stretched by 5% in the length direction at a rate of 100 µm/sec. by using Tensilon manufactured by Toyo Baldwin Co., Ltd. After the laminate film was held in the stretched state for one minute, it was returned to the original position at the same rate (100 µm/sec.).

The evaluation results were shown in Table 1.

### (3) Measurement of oxygen transmittance

The oxygen transmittance of the laminate film was measured by using the oxygen transmission device (OXTRAN2/20, manufactured by Modern Control Corp.) under conditions of a temperature of 30°C and relative humidity 70%. The measuring method was compliant with JIS K-7126 "B method (isopiestic method)" and ASTM D3985-81, and the measurements were shown in the unit of cm³ (STP)/(m²·day·MPa).

The evaluation results were shown in Table 1.

The test results in the "before abuse" in Table 1 show the measurement results of oxygen transmittance for only the gas-barrier laminate film (the gas-barrier laminate film which does not include another laminate). Further, the test results in the "after abuse" in Table 1 show the measurement results of oxygen transmittance for the laminate film subject to the above "(1) Evaluation of bending resistance" and the laminate film subject to the above "(2) Evaluation of stretch resistance."

**[Table 1]**

| | Order of application of coating liquid | Mass ratio of PVA/TEOS (SiO convertion) | Degree of polymerization of PVA | Polyacrylic acid zinc neutralization | Oxygen transmission [cm³ (STP)/(m²·day·MPa)] | | |
|---|---|---|---|---|---|---|---|
| | | | | | Before abuse | After abuse | |
| | | | | | | After bending | After stretching |
| Example 1 | a1/b1 | 50/50 | 2400 | Yes | 0.6 | 3 | 0.8 |
| Example 2 | b1/a1 | 50/50 | 2400 | Yes | 0.6 | 3 | 0.8 |
| Example 3 | a4/b1 | 50/50 | 1000 | Yes | 0.6 | 4 | 1.0 |
| Example 4 | b1/a4 | 50/50 | 1000 | Yes | 0.6 | 4 | 1.0 |
| Example 5 | a2/b1 | 70/30 | 2400 | Yes | 1.5 | 3 | 1.0 |
| Example 6 | b1/a2 | 70/30 | 2400 | Yes | 1.5 | 3 | 1.0 |
| Example 7 | a1/b2 | 50/50 | 2400 | No | 1.5 | 3 | 0.8 |
| Example 8 | b2/a1 | 50/50 | 2400 | No | 1.5 | 3 | 0.8 |
| Comparative example 1 | a1 | 50/50 | 2400 | - | 2 | 11 | 3 |
| Comparative example 2 | a2 | 70/30 | 2400 | - | 3 | 11 | 4 |
| Comparative example 3 | a3 | 30/70 | 2400 | - | 0.5 | 78 | 530 |
| Comparative example 4 | b1 | - | - | Yes | 3 | 12 | 3 |

As seen from the results in Table 1, it was revealed that use of the gas-barrier laminate film of Examples 1 to 8 can provide a laminate film having good gas barrier properties and good abuse resistance in which the gas barrier properties is resistant to bending, stretching and the like.

### [Industrial Applicability]

The gas-barrier laminate film of the present invention is a laminate film having good gas barrier properties and gas barrier properties resistant to abuse such as bending, stretching and the like. Use of the gas-barrier laminate film of the present invention with the post-processing such as printing process, dry lamination, melt extrusion lamination or thermal press fitting lamination can provide packaging materials having a wide application of use in the field of package such as food products, pharmaceutical products and the like.

### Reference Signs List

- 1: Film base material
- 2: Inorganic compound layer (A¹)
- 3: Carboxylic acid polymer layer (B¹)
- 4: Silicon compound-containing layer (C¹)
- 5: Gas-barrier laminate film

## Claims

1. A gas-barrier laminate film comprising:
a film base material;
a layer that contains an inorganic compound (A) and is formed on one surface of the film base material; and
two layers formed on the layer that contains the inorganic compound (A) so as to be adjacent to each other, wherein
the two layers are made up of a layer that contains a carboxylic acid polymer (B); and
a layer that contains at least one selected from a group consisting of a silicon compound (C) represented by a general formula (1) and a hydrolysate thereof, and a vinyl alcohol polymer (D):
Si(OR¹)₄ (1)
(where R¹ represents an alkyl group with 1-4 carbon atoms, and the four R¹s may be identical or different).

2. The gas-barrier laminate film according to claim 1, wherein the layer that contains the inorganic compound (A) is formed by a vapor deposition method, and made of at least one selected from a group consisting of aluminum, aluminum oxide, tin oxide, magnesium oxide and silicon oxide.
